# EUROPEAN PATENT SPECIFICATION

(11) **EP 4 330 450 B1**
(45) Date of publication and mention of the grant of the patent: **28.01.2026**
(21) Application number: 22724540.4
(22) Date of filing: 27.04.2022
(51) Int. Cl.: C30B 15/20, C30B 15/30, C30B 29/06, C30B 30/04

(54) **METHODS FOR PRODUCING SILICON INGOTS BY HORIZONTAL MAGNETIC FIELD CZOCHRALSKI**
VERFAHREN ZUR HERSTELLUNG VON SILICIUMBLÖCKEN DURCH DAS HORIZONTALE MAGNETFELD-CZOCHRALSKI
PROCÉDÉS DE PRODUCTION DE LINGOTS DE SILICIUM PAR CZOCHRALSKI À CHAMP MAGNÉTIQUE HORIZONTAL

(30) Priority: 28.04.2021 US 202163180993 P
(43) Date of publication of application: 06.03.2024
(73) Proprietor: GlobalWafers Co., Ltd., Hsinchu (TW)
(72) Inventor: RYU, JaeWoo, St. Peters, Missouri 63376 (US); DAGGOLU, Parthiv, St. Peters, Missouri 63376 (US); BASAK, Soubir, St. Peters, Missouri 63376 (US); ZHANG, Nan, St. Peters, Missouri 63376 (US)
(74) Representative: Maiwald GmbH
(86) International application number: PCT/US2022/026590
(87) International publication number: WO 2022/232310

(56) References cited:
- KR-A- 20100 089 457
- KR-A- 20110 112 790
- US-A- 5 178 720
- US-A1- 2009 183 670
- US-A1- 2016 160 388
- US-A1- 2018 355 509
- US-A1- 2019 017 191
- US-A1- 2020 216 975

## Description

### FIELD OF THE INVENTION

The field of the invention relates to methods for producing single crystal silicon ingots in a horizontal magnetic field Czochralski process and, in particular, methods for producing single crystal silicon ingots with reduced oxygen content.

### BACKGROUND

Single crystal silicon is the starting material in many processes for fabricating semiconductor electronic components and solar materials. For example, semiconductor wafers produced from silicon ingots are commonly used in the production of integrated circuit chips on which circuitry is printed. In the solar industry, single crystal silicon may be used instead of multicrystalline silicon due to the absence of grain boundaries and dislocations.

To produce semiconductor or solar wafers, a single crystal silicon ingot may be produced in a Czochralski process by dipping a seed crystal into molten silicon held within a crucible. The seed crystal is withdrawn in a manner sufficient to achieve the diameter desired for the ingot, and growing the ingot at that diameter. For a continuous single crystal silicon process, the method is similar to that of a batch process except the polysilicon is fed and melted simultaneously with crystal growth. The silicon ingot is then machined into a desired shape from which the semiconductor or solar wafers can be produced.

During the process, oxygen (Oi) is introduced into silicon crystal ingots through the melt-crystal interface. The oxygen may cause various defects in wafers produced from the ingots, reducing the yield of semiconductor devices fabricated using the ingots. For example, insulated-gate bipolar transistors (IGBTs), high quality radio-frequency (RF), high resistivity silicon on insulator (HR-SOI), and charge trap layer SOI (CTL-SOI) applications typically require a relatively low oxygen concentration in order to achieve high resistivity and to avoid formation of P-N junctions.

At least some known methods use float zone materials to achieve a low oxygen concentration and high resistivity. However, float zone materials are relatively expensive and are limited to use in producing ingots having a diameter less than about 200 mm. Accordingly, these known methods are unable to produce higher diameter silicon crystal ingots with a relatively low oxygen concentration.

A need exists for methods for producing single crystal silicon ingots with relatively low oxygen concentration.

US 2020/216975 A1 describes a method for growing a single-crystal silicon ingot wherein the interstitial oxygen is controlled to within a required range by optimization of crucible inner wall temperature and crucible dissolution, transport of Oi from crucible wall to the growing crystal, and evaporation of SiO from the melt surface to gas phase. US 2019/017191 A1 describes a single-crystal ingot growing method comprising setting a location of a maximum gauss position (MGP) of a magnetic field such that the MGP is located above the surface of the melt, setting a difference in intensity of the magnetic field between a center point of the melt and an edge point of the melt based on the set location of the MGP, and setting an intensity of the magnetic field that is applied to the melt based on the set difference in intensity of the magnetic field.

This section is intended to introduce the reader to various aspects of art that may be related to various aspects of the invention, which are described and/or claimed below. This discussion is believed to be helpful in providing the reader with background information to facilitate a better understanding of the various aspects of the present invention. Accordingly, it should be understood that these statements are to be read in this light, and not as admissions of prior art.

### SUMMARY

The present invention is directed to a method for producing a silicon ingot. The method includes melting polycrystalline silicon in a crucible enclosed in a vacuum chamber to form a melt. The melt has a melt free surface. A horizontal magnetic field is generated within the vacuum chamber. A seed crystal is dipped into the melt. The seed crystal is withdrawn from the melt to form the silicon ingot. A plurality of process parameters are simultaneously regulated to reduce the oxygen concentration in the silicon ingot to less than 5 ppma. The plurality of process parameters include a wall temperature of the crucible, a transport of silicon monoxide (SiO) from the crucible to the silicon ingot, and an evaporation rate of SiO from the melt. Simultaneously regulating a plurality of process parameters comprises maintaining the position of a maximum gauss plane of the horizontal magnetic field above the melt free surface; generating the horizontal magnetic field at a magnetic flux density of from 0.15 Tesla to 0.4 Tesla; and rotating the crucible (i) opposite a direction at which the ingot is rotated or (ii) in the same direction at which the ingot is rotated. When the crucible is rotated opposite a direction at which the ingot is rotated, the crucible is rotated at a rate in a range from 0.1 RPM to 1.2 RPM. When the crucible is rotated in the same direction at which the ingot is rotated, the crucible is rotated at a rate in a range from 1.2 RPM to 5.0 RPM.

### BRIEF DESCRIPTION OF THE DRAWINGS

FIG. 1 is a top view of a crucible and a cylindrical coordinate system;
FIG. 2 is a side view of the crucible and a cylindrical coordinate system;
FIG. 3 is a schematic diagram illustrating a cusped magnetic field applied to a crucible containing a melt in a crystal growing apparatus;
FIG. 4 is a block diagram of a crystal growing system;
FIG. 5 is a diagram of the magnitude of the horizontal and vertical components of a horizontal magnetic field in the melt and crystal domains showing the maximum gauss plane (MGP);
FIG. 6 illustrates flow field diagrams showing in-plane stream traces along planes perpendicular to the horizontal magnetic field with X=0 (center plane), X=-32m, X=+32m, for the case of MGP 80 mm above the melt free surface (+80 mm) and MGP 80 mm below the melt free surface (-80 mm);
FIG. 7 is a graph comparing the radial velocities along the melt free surface in the parallel center plane between the case of MGP 80 mm above the melt free surface (+80 mm) and MGP 80 mm below the melt free surface (-80 mm);
FIG. 8 illustrates flow field diagrams showing in-plane stream traces along planes parallel to the horizontal magnetic field with Y=0 (center plane), Y=-32m, Y=+32m, for the case of MGP 80 mm above the melt free surface (+80 mm) and MGP 80 mm below the melt free surface (-80 mm) ;
FIG. 9 is a graph comparing the radial velocities along the melt free surface in the perpendicular center plane between the case of MGP 80 mm above the melt free surface (+80 mm) and MGP 80 mm below the melt free surface (-80 mm);
FIG. 10 is a graph of the evaporation rate of SiO gas from the melt free surface for the case of MGP 80 mm below the melt free surface (top pane) and MGP 80 mm above the melt free surface (bottom pane);
FIG. 11 illustrates the Oi radial profile in single crystal silicon ingots for the case of MGP 80 mm below the melt free surface (-80 mm) and MGP 80 mm above the melt free surface (+80 mm);
FIG. 12 is a graph of the Oi vs MGP position in HMCZ and comparison with experimental data;
FIG. 13 illustrates flow field diagrams showing in-plane stream traces along planes perpendicular to the horizontal magnetic field with X=0 (center plane), X=-32m, X=+32m, for the case of crucible counter rotation of -0.6 RPM and a MGP position of 80 mm below the melt free surface (left pane) and crucible counter rotation of -1.6 RPM at a MGP position of 80 mm above the melt free surface (right pane);
FIG. 14 is a graph of the Oi radial profile in single crystal silicon ingots for the case of crucible counter rotation of -0.6 RPM and crucible counter rotation of -1.6 RPM; and
FIG. 15 is a graph of the Oi radial profile in single crystal silicon ingots for the case of a magnetic field strength of 0.22T and a magnetic field strength of 0.44T.

Corresponding reference characters indicate corresponding parts throughout the drawings.

### DETAILED DESCRIPTION

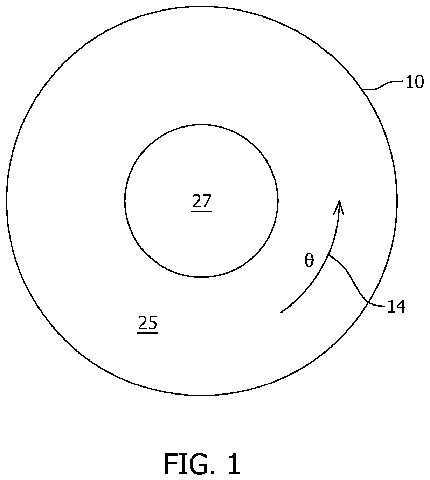

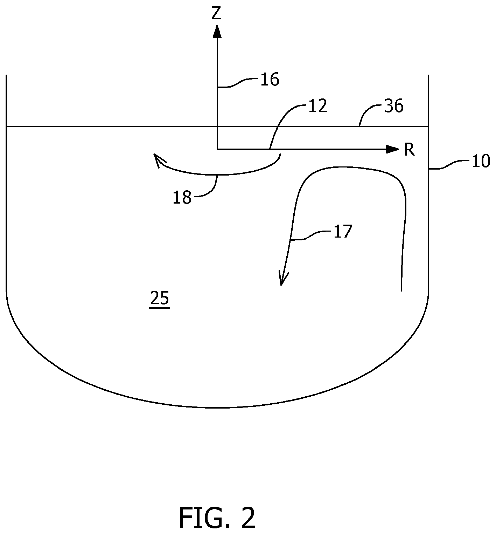

The present invention relates to methods for preparing relatively low oxygen single crystal silicon ingots by a horizontal magnetic field Czochralski (HMCZ) process. Referring initially to FIGS. 1 and 2, an example crucible for use with the methods of the present invention is indicated generally at 10. A cylindrical coordinate system for crucible 10 includes a radial direction R 12, an angular direction θ 14, and an axial direction Z 16. The crucible 10 contains a melt 25 having a melt surface 36. A crystal 27 is grown from the melt 25. The melt 25 may contain one or more convective flow cells 17, 18 induced by heating of the crucible 10 and rotation of the crucible 10 and/or crystal 27 in the angular direction θ 14. The structure and interaction of these one or more convective flow cells 17, 18 are modulated via regulation of one or more process parameters and/or the application of a magnetic field as described in detail herein below.

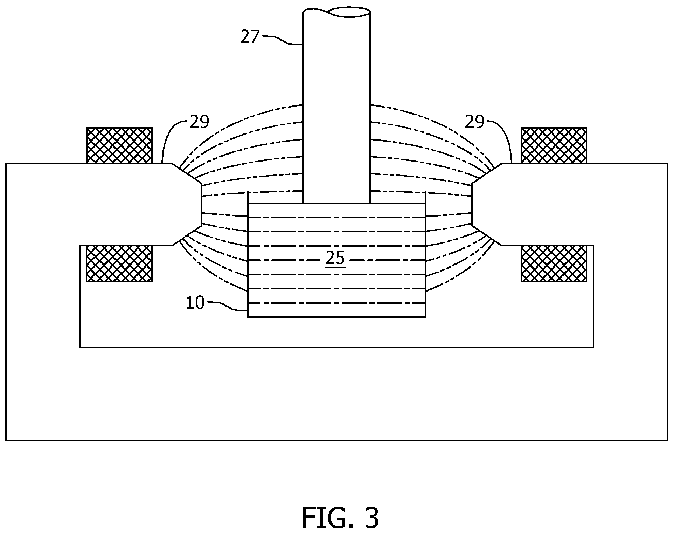

FIG. 3 is a diagram illustrating a horizontal magnetic field being applied to crucible 10 containing melt 25 in a crystal growing apparatus. As shown, crucible 10 contains silicon melt 25 from which a crystal 27 is grown. The transition between the melt and the crystal is generally referred to as the crystal-melt interface (alternatively the melt-crystal, solid-melt or melt-solid interface) and is typically non-linear, for example concave, convex or gull-winged relative to the melt surface. Two magnetic poles 29 are placed in opposition to generate a magnetic field generally perpendicular to the crystal-growth direction and generally parallel to the melt surface 36. The magnetic poles 29 may be a conventional electromagnet, a superconductor electromagnet, or any other suitable magnet for producing a horizontal magnetic field of the desired strength. Application of a horizontal magnetic field gives rise to Lorentz force along the axial direction, in a direction opposite of fluid motion, opposing forces driving melt convection. The convection in the melt is thus suppressed, and the axial temperature gradient in the crystal near the interface increases. The melt-crystal interface then moves upward to the crystal side to accommodate the increased axial temperature gradient in the crystal near the interface and the contribution from the melt convection in the crucible decreases. The horizontal configuration has the advantage of efficiency in damping a convective flow at the melt surface 36.

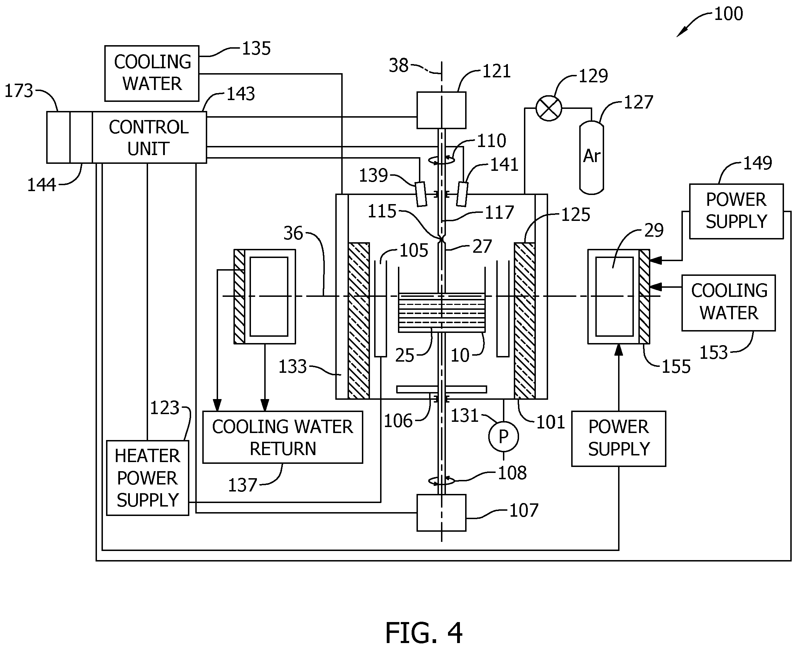

FIG. 4 is a block diagram of a crystal growing system 100. System 100 employs a Czochralski crystal growth method to produce a semiconductor ingot. In this embodiment, system 100 is configured to produce a cylindrical semiconductor ingot having an ingot diameter of 150 mm, greater than 150 mm, more specifically in a range from approximately 150 mm to 460 mm, and even more specifically, a diameter of approximately 300 mm. In other embodiments, system 100 is configured to produce a semiconductor ingot having a 200 mm ingot diameter or a 450 mm ingot diameter. In addition, in one embodiment, system 100 is configured to produce a semiconductor ingot with a total ingot length of at least 900 mm. In some embodiments, the system is configured to produce a semiconductor ingot with a length of 1950 mm, 2250 mm, 2350 mm, or longer than 2350 mm. In other embodiments, system 100 is configured to produce a semiconductor ingot with a total ingot length ranging from approximately 900 mm to 1200 mm, between approximately 900 mm and approximately 2000 mm, or between approximately 900 mm and approximately 2500 mm. In some embodiments, the system is configured to produce a semiconductor ingot with a total ingot length greater than 2000 mm.

The crystal growing system 100 includes a vacuum chamber 101 enclosing crucible 10. A side heater 105, for example, a resistance heater, surrounds crucible 10. A bottom heater 106, for example, a resistance heater, is positioned below crucible 10. During heating and crystal pulling, a crucible drive unit 107 (e.g., a motor) rotates crucible 10, for example, in the clockwise direction as indicated by the arrow 108. Crucible drive unit 107 may also raise and/or lower crucible 10 as desired during the growth process. Within crucible 10 is silicon melt 25 having a melt level or melt surface 36. In operation, system 100 pulls a single crystal 27, starting with a seed crystal 115 attached to a pull shaft or cable 117, from melt 25. One end of pull shaft or cable 117 is connected by way of a pulley (not shown) to a drum (not shown), or any other suitable type of lifting mechanism, for example, a shaft, and the other end is connected to a chuck (not shown) that holds seed crystal 115 and crystal 27 grown from seed crystal 115.

Crucible 10 and single crystal 27 have a common axis of symmetry 38. Crucible drive unit 107 can raise crucible 10 along axis 38 as the melt 25 is depleted to maintain the melt surface 36 at a desired height. A crystal drive unit 121 similarly rotates pull shaft or cable 117 in a direction 110 opposite the direction in which crucible drive unit 107 rotates crucible 10 (e.g., counter rotation). In embodiments using iso-rotation, crystal drive unit 121 may rotate pull shaft or cable 117 in the same direction in which crucible drive unit 107 rotates crucible 10 (e.g., in the clockwise direction). Iso-rotation may also be referred to as a co-rotation. In addition, crystal drive unit 121 raises and lowers crystal 27 relative to the melt surface 36 as desired during the growth process.

According to the Czochralski single crystal growth process, a quantity of polycrystalline silicon, or polysilicon, is charged to crucible 10. A heater power supply 123 energizes resistance heaters 105 and 106, and insulation 125 lines the inner wall of vacuum chamber 101. A gas supply 127 feeds an inert gas such as argon to the vacuum chamber 101 via a gas flow controller 129 as a vacuum pump 131 removes gas from vacuum chamber 101. An outer chamber 133, which is fed with cooling water from a reservoir 135, surrounds vacuum chamber 101.

The cooling water is then drained to a cooling water return manifold 137. Typically, a temperature sensor such as a photocell 139 (or pyrometer) measures the temperature of melt 25 at its surface, and a diameter transducer 141 measures a diameter of the silicon ingot 27. In this embodiment, system 100 does not include an upper heater. The presence of an upper heater, or lack of an upper heater, alters cooling characteristics of crystal 27.

Magnetic poles 29 are positioned outside the vacuum chamber 101 to produce a horizontal magnetic field. Although illustrated approximately centered on the melt surface 36, the position of the magnetic poles 29 relative to the melt surface 36 may be varied to adjust the position of the maximum gauss plane (MGP) relative to the melt surface 36. A reservoir 153 (FIG. 4) provides cooling water to the magnetic poles 29 before draining via cooling water return manifold 137. A ferrous shield 155 surrounds magnetic poles 29 to reduce stray magnetic fields and to enhance the strength of the field produced.

A control unit 143 is used to regulate the plurality of process parameters. In various embodiments, the control unit 143 may include a memory 173 and processor 144 that processes the signals received from various sensors of the system 100 including photocell 139 and diameter transducer 141, as well as to control one or more devices of system 100 including: crucible drive unit 107, crystal drive unit 121, heater power supply 123, vacuum pump 131, gas flow controller 129 (e.g., an argon flow controller), magnetic poles power supply 149, and any combination thereof. The memory 173 may store instructions that, when executed by the processor 144, cause the processor to perform one or more of the methods described herein. That is, the instructions configure the control unit 143 to perform one or more of the methods, processes, and procedures described herein.

Control unit 143 may be a computer system. Computer systems, as described herein, refer to any known computing device and computer system. As described herein, all such computer systems include a processor and a memory. However, any processor in a computer system referred to herein may also refer to one or more processors wherein the processor may be in one computing device or a plurality of computing devices acting in parallel. Additionally, any memory in a computer device referred to herein may also refer to one or more memories wherein the memories may be in one computing device or a plurality of computing devices acting in parallel. Further, the computer system may be located near the system 100 (e.g., in the same room, or in an adjacent room), or may be remotely located and coupled to the rest of the system via a network, such as an Ethernet or the Internet.

The term processor, as used herein, refers to central processing units, microprocessors, microcontrollers, reduced instruction set circuits (RISC), application specific integrated circuits (ASIC), logic circuits, and any other circuit or processor capable of executing the functions described herein. The above are examples only, and are thus not intended to limit in any way the definition and/or meaning of the term "processor." The memory may include random access memory (RAM) such as dynamic RAM (DRAM) or static RAM (SRAM), read-only memory (ROM), erasable programmable read-only memory (EPROM), electrically erasable programmable read-only memory (EEPROM), and non-volatile RAM (NVRAM) .

In one embodiment, a computer program is provided to enable control unit 143, and this program is embodied on a computer readable medium. The computer readable medium may include the memory 173 of the control unit 143. In an example embodiment, the computer system is executed on a single computer system. Alternatively, the computer system may comprise multiple computer systems, connection to a server computer, or a cloud computing environment. In some embodiments, the computer system includes multiple components distributed among a plurality of computing devices. One or more components may be in the form of computer-executable instructions embodied in a computer-readable medium.

The computer systems and processes are not limited to the specific examples described herein. In addition, components of each computer system and each process can be practiced independent and separate from other components and processes described herein. Each component and process also can be used in combination with other assembly packages and processes.

The computer system may be configured to receive measurements from one or more sensors including: temperature sensor 139, diameter transducer 141, and any combination thereof, as well as to control one or more devices of system 100 including: crucible drive unit 107, crystal drive unit 121, heater power supply 123, vacuum pump 131, gas flow controller 129 (e.g., an argon flow controller), magnetic poles power supply 149, and any combination thereof as described herein and illustrated in Fig. 4. The computer system performs all of the steps used to control one or more devices of system 100 as described herein.

In accordance with the present invention, while generating a horizontal magnetic field within the vacuum chamber 101, a plurality of process parameters are simultaneously regulated to reduce the oxygen concentration in the silicon ingot 27. The plurality of process parameters include a wall temperature of the crucible, a transport of silicon monoxide (SiO) from the crucible to the single crystal, and an evaporation rate of SiO from the melt.

In the present invention, three process parameters are regulated simultaneously to facilitate producing silicon crystal ingots with a low oxygen concentration. Specifically, a wall temperature of crucible 10, a flow (i.e., transport) of silicon monoxide (SiO) from crucible 10 to single crystal 27, and an evaporation of SiO from melt 25 are controlled. The wall temperature of the crucible 10 corresponds to a dissolution rate of the crucible 10. Specifically, the higher the wall temperature of the crucible 10, the faster that portions of the crucible 10 will react with and dissolve into the melt 25, generating SiO and increasing an oxygen concentration of the crystal 27. Accordingly, reducing the wall temperature of crucible 10, as used herein, equates to reducing the dissolution rate of crucible 10.

By reducing the wall temperature of crucible 10 (i.e., reducing the dissolution rate of crucible 10), reducing the flow (i.e., transport) of SiO from the crucible 10 to the single crystal 27, and increasing evaporation of SiO from the melt 25, the oxygen concentration of the ingot 27 can be reduced. To regulate the three process parameters, a plurality of conditions are controlled. Each condition affects at least one of the three process parameters. The controlled conditions are the position of the maximum gauss plane, magnetic field strength, and crucible rotation rate. Each condition is described in detail herein.

In the present invention, regulating a plurality of process parameters comprises maintaining the position of a maximum gauss plane ("MGP") of the horizontal magnetic field above the melt free surface 36. The MGP is characterized by the maximum magnitude of the horizontal component of the magnetic field and a zero vertical component along the MGP. The position of the magnetic poles 29 relative to the melt free surface 36 may be varied to adjust the position of the maximum gauss plane (MGP) relative to the melt surface 36. In some embodiments, the maximum gauss plane is maintained at a position at least 20 mm above the melt free surface 36 or least 40 mm above the melt free surface 36, at least 60 mm above the melt free surface 36, from the melt free surface 36 to 150 mm above the melt free surface, or from the melt free surface 36 to 100 mm above the melt free surface. In some embodiments, the maximum gauss plane is maintained at this position (i.e., the same position) during growth of the entire ingot main body (i.e., constant diameter portion of the ingot).

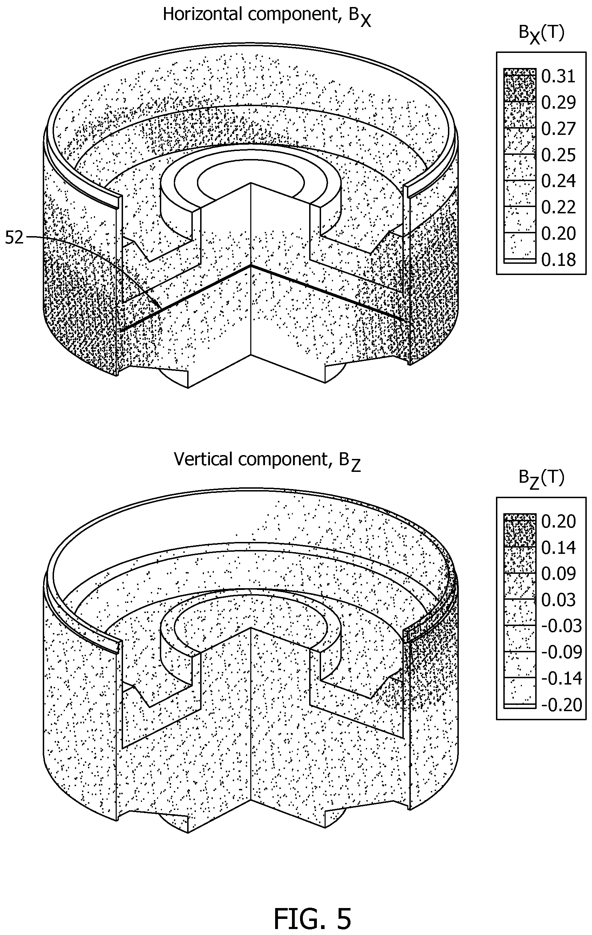

Simultaneously regulating a plurality of process parameters includes generating the horizontal magnetic field at a magnetic flux density of from 0.15 Tesla to 0.4 Tesla. Generally, the strength of the magnetic field is its magnitude at the center of the maximum gauss plane 52 (FIG. 5).

In some embodiments (e.g., for lower Oi concentration), simultaneously regulating a plurality of process parameters comprises rotating the crucible opposite a direction at which ingot is rotated with the crucible being rotated at a rate in a range from 0.1 RPM to 1.6 RPM (i.e., -0.1 RPM to -1.6 RPM) or from 0.1 RPM to 1.2 RPM (i.e., -0.1 RPM to -1.2 RPM). In other embodiments, simultaneously regulating a plurality of process parameters comprises rotating the crucible in the same direction at which ingot is rotated with the crucible being rotated at a rate in a range from 1.2 RPM to 5.0 RPM.

Simultaneously regulating a plurality of process parameters described above may result in silicon ingots having a relatively low concentration of oxygen incorporated therein. The resulting silicon ingots have an oxygen concentration of less than 5 ppma.

### EXAMPLES

The processes of the present invention are further illustrated by the following Examples. These Examples should not be viewed in a limiting sense.

### Example 1: Effect of MGP Position on Oi Concentration

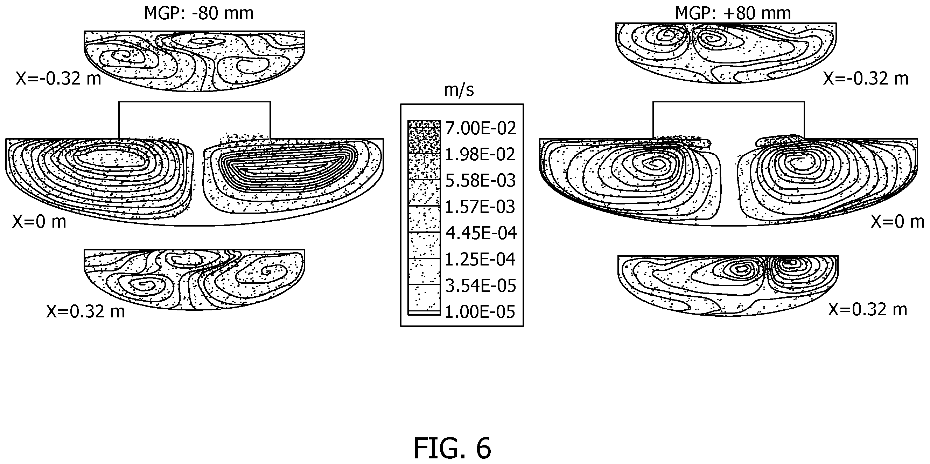

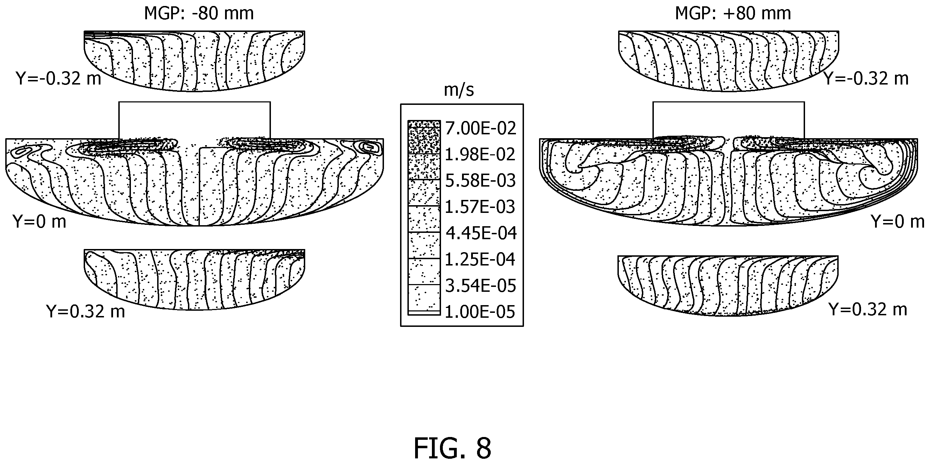

FIG. 6 compares the flow fields along the planes that lie perpendicular to the applied horizontal magnetic field when the maximum gauss plane was 80 mm below the melt surface ("MGP -80 mm") and the maximum gauss plane was 80 mm above the melt surface ("MGP +80 mm"). FIG. 8 compares the flow field along planes that lie parallel to the magnetic field.

There are some similarities in flow features between the two positions - recirculating flow cells are established only in the perpendicular planes and absent in the parallel planes. In addition, both positions of the MGP develop a buoyancy cell in the bulk of the melt and a Taylor-Proudman cell underneath the rotating crystal.

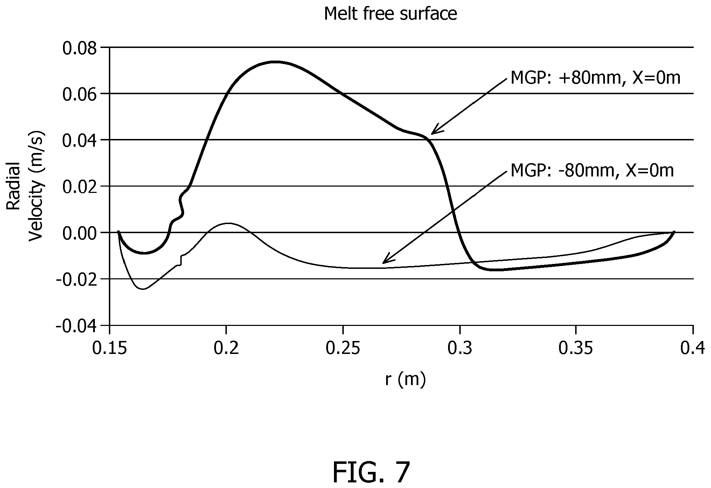

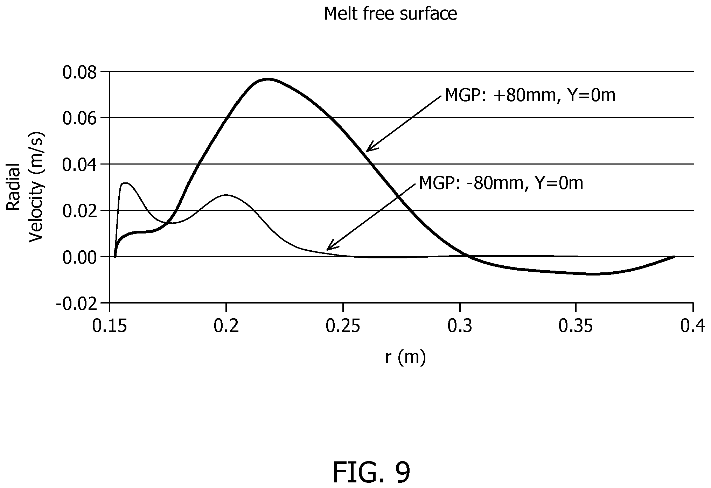

FIG. 7 and FIG. 9 each compare radial velocities along the melt surface between the two cases, in parallel and perpendicular center planes (FIG. 7 being planes that lie perpendicular to the applied horizontal magnetic field and FIG. 9 being planes that lie parallel to the applied horizontal magnetic field). Melt surface velocities were found to be higher overall for the case of MGP positioned above the melt surface, in both the planes, compared to the case of MGP positioned below the melt surface. Higher melt surface velocities enhance evaporation rates of SiO gas driving down the oxygen levels in melt for comparable crucible dissolution rates.

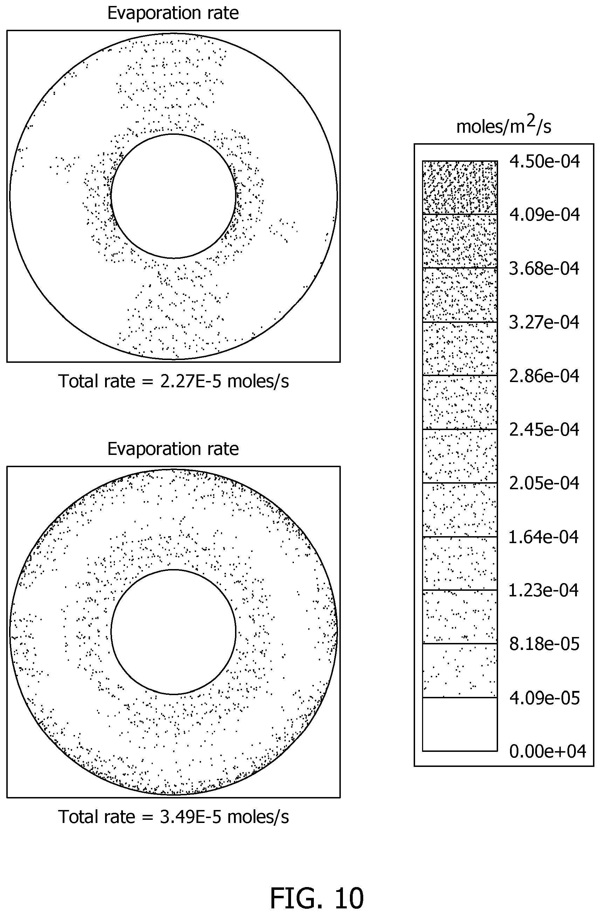

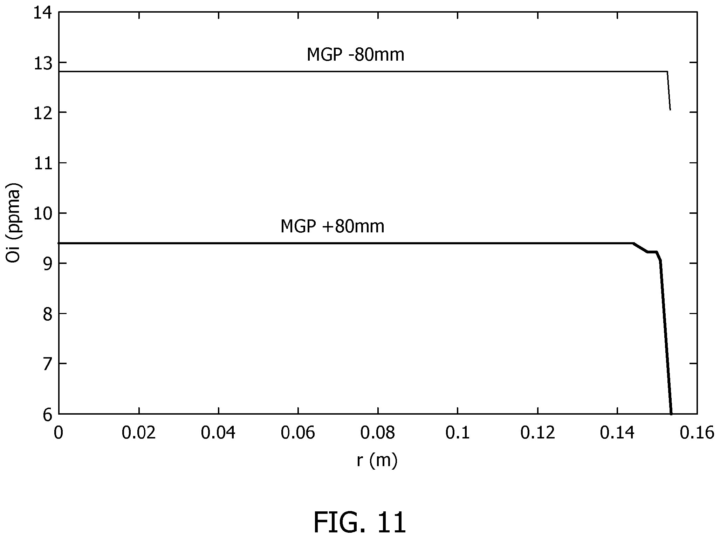

FIG. 10 shows higher net SiO gas evaporation rates from the melt surface for the case of MGP 80 mm above the melt free surface (bottom graph) relative to the case of MGP 80 mm below the melt free surface (top graph), consistent with the flow field, as higher melt surface velocities enhance evaporation rates. This results in a lower oxygen level in the melt and Oi incorporated into the crystal, for comparable crucible dissolution rates, as shown in FIG. 11 in which the Oi radial profiles in the crystal are compared for the two cases.

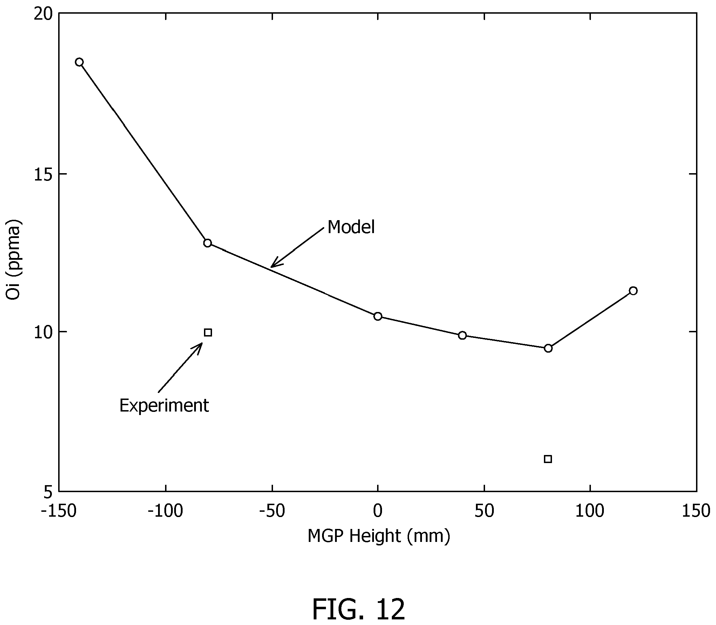

The model calculations were repeated for various other MGP positions to reveal the Oi and MGP position relationship. As shown in FIG. 12, the relationship was found to be non-monotonic with a minimum Oi value around a position at which MGP was 80 mm above the melt free surface. In addition, the model results are compared with the experimental Oi measurements from the ingots grown under the conditions at which the MGP was 80 mm below the melt free surface and 80 mm above the melt free surface (other process conditions were maintained similar between the model and experiments). Although the absolute Oi values differ, the model followed the directional trend in Oi with respect to the MGP position observed experimentally.

### Example 2: Effect of Crucible Counter Rotation Rate on Oi Concentration

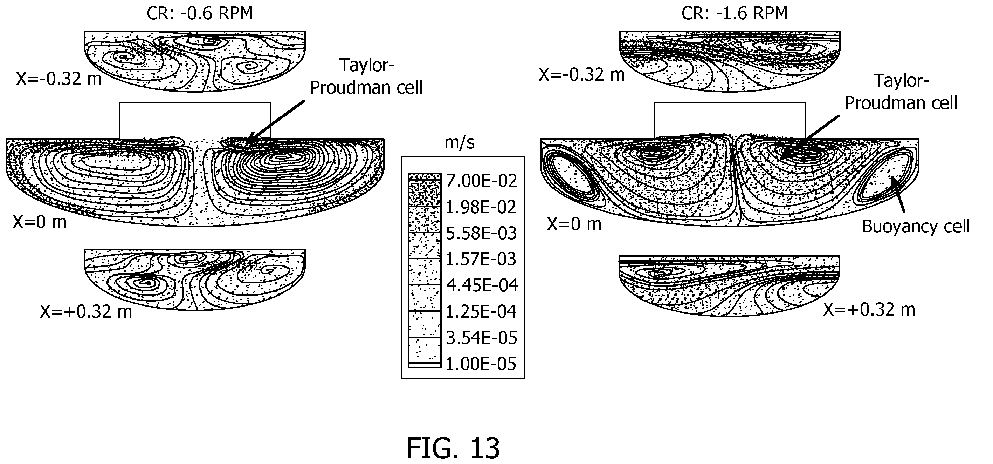

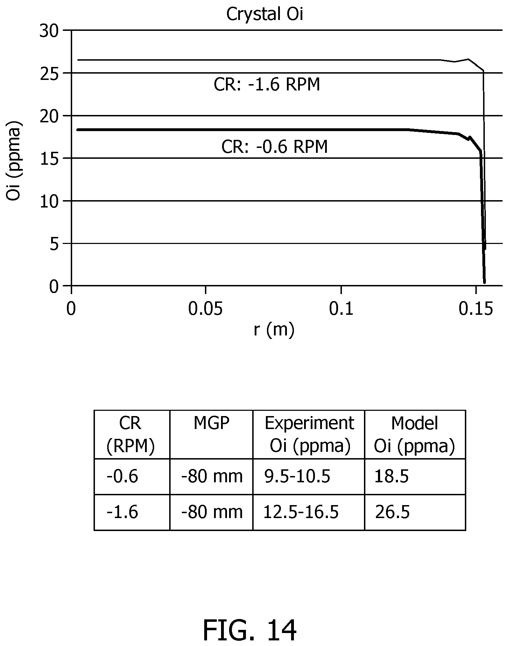

The crucible counter rotation rate was increased from 0.6 RPM to 1.6 RPM. The model predicted that the flow structures in the perpendicular center plane underwent a distinct transformation. As shown in FIG. 13, the buoyancy cell was squeezed and the Taylor-Proudman cell driven by crystal rotation occupied the bulk of the melt in the latter case. The flow was primarily upward at the center enhancing the transport of oxygen from crucible bottom into the ingot. In addition, the buoyancy cell is not exposed to the melt surface resulting in a choking of the SiO evaporation rates. These effects result in higher oxygen levels in the latter case, as shown in FIG. 14, consistent with the experimental observations shown below.

**Table 1: Comparison of Model and Experimental Values**

| **CR (RPM)** | **MGP** | **Experiment Oi (ppma)** | **Model Oi (ppma)** |
|---|---|---|---|
| -0.6 | -80 mm | 9.5-10.5 | 18.5 |
| -1.6 | -80 mm | 12.5-16.5 | 26.5 |

### Example 3: Effect of Magnetic Field Strength on Oi Concentration

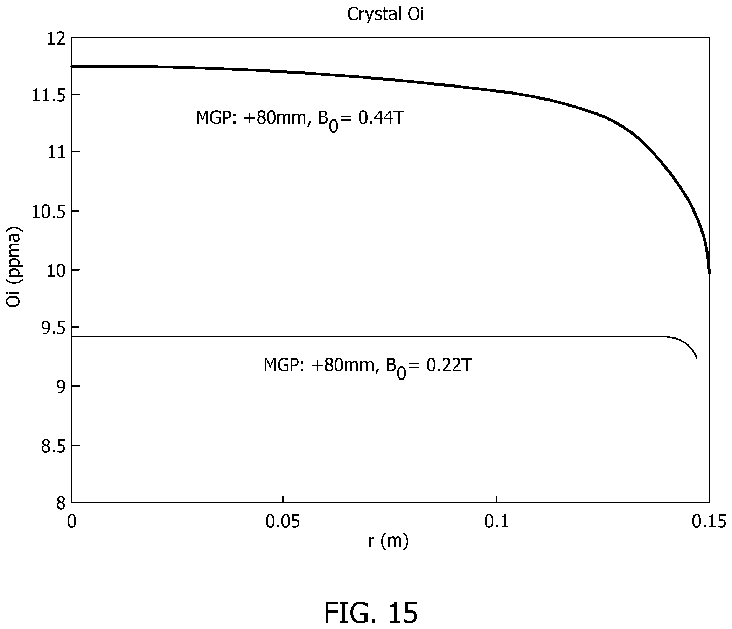

Referring now to FIG. 15, the model predicts a non-monotonic behavior of Oi with increasing magnetic field strength. Increasing the magnetic field acts to suppress the melt convection and turbulence affecting the boundary layer thickness at both the crucible/melt interface (decreasing the dissolution rate) and the melt/gas interface (decreasing the evaporation rate). At optimum field strengths, the resulting melt flow retards the crucible dissolution rates, while relatively unaffecting the evaporation rates, to yield low Oi. As shown in FIG. 15, reducing the magnetic field strength to 0.22T reduced the oxygen concentration in the ingot.

### Example 4: Effect of MGP Position and Crucible Rotation Rate on Oi Concentration

Two 300 mm ingots were grown at a constant magnetic field strength of about 3000 Gauss. The crucible rotation rate was maintained constant at -2 RPM (i.e., counter-rotation) for both ingots. "Ingot 1" was grown with MGP 130 mm below the melt free surface (-130 mm MGP) and "Ingot 2" was grown at 80 mm above the melt free surface (+80 mm MGP). As shown in Table 2 below, lower oxygen was achieved with the higher MGP of +80 mm.

"Ingot 3" was a 300 mm ingot also grown at a constant magnetic field strength of about 3000 Gauss. Ingot 3 was grown with a MGP of +80 mm and the crucible rotation rate was decreased to -0.1 RPM. As shown when comparing Ingot 2 and Ingot 3, lower oxygen was achieved when the crucible rotation rate was lowered to -0.1 RPM.

**Table 2: Comparison of Oi with Different MGP and Crucible Rotation**

| | Magnetic field, G | MGP, mm | C/R, rpm | Oxygen, nppma |
|---|---|---|---|---|
| Ingot 1 | 3000 | -130 | -2 | 17.0 |
| Ingot 2 | 3000 | 80 | -2 | 14.5 |
| Ingot 3 | 3000 | 80 | -0.1 | 7.9 |

As used herein, the terms "about," "substantially," "essentially" and "approximately" when used in conjunction with ranges of dimensions, concentrations, temperatures or other physical or chemical properties or characteristics is meant to cover variations that may exist in the upper and/or lower limits of the ranges of the properties or characteristics, including, for example, variations resulting from rounding, measurement methodology or other statistical variation.

When introducing elements of the present invention or the embodiment(s) thereof, the articles "a," "an," "the," and "said" are intended to mean that there are one or more of the elements. The terms "comprising," "including," "containing," and "having" are intended to be inclusive and mean that there may be additional elements other than the listed elements. The use of terms indicating a particular orientation (e.g., "top," "bottom," "side," etc.) is for convenience of description and does not require any particular orientation of the item described.

## Claims

1. A method for producing a silicon ingot, the method comprising:
melting polycrystalline silicon in a crucible enclosed in a vacuum chamber to form a melt, the melt having a melt free surface;
generating a horizontal magnetic field within the vacuum chamber;
dipping a seed crystal into the melt;
withdrawing the seed crystal from the melt to form the silicon ingot; and
simultaneously regulating a plurality of process parameters to reduce the oxygen concentration in the silicon ingot to less than 5 ppma, wherein the plurality of process parameters include a wall temperature of the crucible, a transport of SiO from the crucible to the silicon ingot, and an evaporation rate of SiO from the melt, wherein simultaneously regulating a plurality of process parameters comprises:
maintaining the position of a maximum gauss plane of the horizontal magnetic field above the melt free surface;
generating the horizontal magnetic field at a magnetic flux density of from 0.15 Tesla to 0.4 Tesla; and
rotating the crucible (i) opposite a direction at which the ingot is rotated or (ii) in the same direction at which the ingot is rotated, wherein:
when the crucible is rotated opposite a direction at which the ingot is rotated, the crucible is rotated at a rate in a range from 0.1 RPM to 1.2 RPM; and
when the crucible is rotated in the same direction at which the ingot is rotated, the crucible is rotated at a rate in a range from 1.2 RPM to 5.0 RPM.

2. The method as set forth in claim 1 wherein the maximum gauss plane is maintained at a position at least 20 mm above the melt free surface.

3. The method as set forth in claim 1 wherein the maximum gauss plane is maintained at a position at least 40 mm above the melt free surface.

4. The method as set forth in claim 1 wherein the maximum gauss plane is maintained at a position at least 60 mm above the melt free surface.

5. The method as set forth in claim 1 wherein the maximum gauss plane is maintained at a position from the melt free surface to 150 mm above the melt free surface.

6. The method as set forth in any one of claims 1 to 5 wherein the silicon ingot has a diameter of 300 mm or more.

7. The method as set forth in any one of claims 1 to 5 wherein the silicon ingot has a diameter of 300 mm.

## Patentansprüche

1. Ein Verfahren zur Herstellung eines Siliciumeinkristalls, das Verfahren umfassend:
Schmelzen von polykristallinem Silizium in einem Tiegel, der in einer Vakuumkammer eingeschlossen ist, um eine Schmelze zu bilden, wobei die Schmelze eine freie Schmelzoberfläche aufweist;
Erzeugen eines horizontalen Magnetfelds innerhalb der Vakuumkammer;
Eintauchen eines Impfkristalls in die Schmelze;
Herausziehen des Impfkristalls aus der Schmelze, um den Siliciumeinkristall zu erzeugen; und
gleichzeitige Regelung einer Vielzahl von Prozessparametern, um die Sauerstoffkonzentration im Siliciumeinkristall auf weniger als 5 ppma zu reduzieren, wobei die Vielzahl von Prozessparametern eine Wandtemperatur des Tiegels, einen Transport von SiO vom Tiegel zum Siliciumeinkristall und eine Verdampfungsrate von SiO aus der Schmelze umfasst, wobei die gleichzeitige Regelung einer Vielzahl von Prozessparametern umfasst:
Halten der Position einer maximalen Gauß-Ebene des horizontalen Magnetfelds über der freien Schmelzoberfläche;
Erzeugen des horizontalen Magnetfelds mit einer Magnetflussdichte von 0,15 Tesla bis 0,4 Tesla; und
Rotieren des Tiegels (i) entgegen der Richtung, in der der Einkristall rotiert wird, oder (ii) in derselben Richtung, in der der Einkristall rotiert wird, wobei:
der Tiegel mit einer Geschwindigkeit in einem Bereich von 0,1 rpm bis 1,2 rpm rotiert wird, wenn der Tiegel entgegen der Richtung, in der der Einkristall rotiert wird, rotiert wird; und
der Tiegel mit einer Geschwindigkeit in einem Bereich von 1,2 rpm bis 5,0 rpm rotiert wird, wenn der Tiegel in derselben Richtung, in der der Einkristall rotiert wird, rotiert wird.

2. Das Verfahren nach Anspruch 1, wobei die maximale Gauß-Ebene in einer Position mindestens 20 mm über der freien Schmelzoberfläche gehalten wird.

3. Das Verfahren gemäß Anspruch 1, wobei die maximale Gauß-Ebene in einer Position mindestens 40 mm über der freien Schmelzoberfläche gehalten wird.

4. Das Verfahren gemäß Anspruch 1, wobei die maximale Gauß-Ebene in einer Position mindestens 60 mm über der freien Schmelzoberfläche gehalten wird.

5. Das Verfahren gemäß Anspruch 1, wobei die maximale Gauß-Ebene in einer Position von der Schmelzoberfläche bis zu 150 mm über der freien Schmelzoberfläche gehalten wird.

6. Das Verfahren gemäß irgendeinem der Ansprüche 1 bis 5, wobei der Siliciumeinkristall einen Durchmesser von 300 mm oder mehr hat.

7. Das Verfahren gemäß irgendeinem der Ansprüche 1 bis 5, wobei der Siliciumeinkristall einen Durchmesser von 300 mm hat.

## Revendications

1. Procédé destiné à produire un lingot de silicium, le procédé comportant de :
faire fondre du silicium polycristallin dans un creuset enfermé dans une chambre à vide pour former une masse fondue, la masse fondue ayant une surface libre,
générer un champ magnétique horizontal à l'intérieur de la chambre à vide,
tremper un germe cristallin dans la masse fondue,
retirer le germe cristallin de la masse fondue pour former le lingot de silicium, et
réguler simultanément une pluralité de paramètres de traitement pour réduire la concentration d'oxygène dans le lingot de silicium à moins de 5 ppma, la pluralité de paramètres de traitement comprenant une température de paroi du creuset, un transport de SiO du creuset au lingot de silicium et un taux d'évaporation du SiO à partir de la masse fondue, dans lequel la régulation simultanée d'une pluralité de paramètres de traitement comporte de :
maintenir la position d'un plan gaussien maximal du champ magnétique horizontal au-dessus de la surface libre de la masse fondue,
générer le champ magnétique horizontal à une densité de flux magnétique de 0,15 tesla à 0,4 tesla, et
faire tourner le creuset (i) dans le sens opposé à un sens dans lequel le lingot tourne ou (ii) dans le même sens que celui dans lequel le lingot tourne, dans lequel :
lorsque le creuset tourne dans le sens opposé à un sens dans lequel le lingot tourne, le creuset tourne à une vitesse située dans un intervalle de 0,1 t/min à 1,2 t/min, et
lorsque le creuset tourne dans le même sens que celui dans lequel le lingot tourne, le creuset tourne à une vitesse située dans un intervalle de 1,2 t/min à 5,0 t/min.

2. Procédé selon la revendication 1, dans lequel le plan gaussien maximal est maintenu à une position située au moins 20 mm au-dessus de la surface libre de la masse fondue.

3. Procédé selon la revendication 1, dans lequel le plan gaussien maximal est maintenu à une position située au moins 40 mm au-dessus de la surface libre de la masse fondue.

4. Procédé selon la revendication 1, dans lequel le plan gaussien maximal est maintenu à une position située au moins 60 mm au-dessus de la surface libre de la masse fondue.

5. Procédé selon la revendication 1, dans lequel le plan gaussien maximal est maintenu à une position par rapport à la surface exempte de masse fondue située à 150 mm au-dessus de la surface libre de la masse fondue.

6. Procédé selon l'une quelconque des revendications 1 à 5, dans lequel le lingot de silicium présente un diamètre de 300 mm ou plus.

7. Procédé selon l'une quelconque des revendications 1 à 5, dans lequel le lingot de silicium présente un diamètre de 300 mm.
